Europäisches Patentamt

European Patent Office

Office européen des brevets

(19)

(11) Veröffentlichungsnummer: **0 030 006**
**B1**

(12)

# EUROPÄISCHE PATENTSCHRIFT

(45) Veröffentlichungstag der Patentschrift:
**15.06.83**

(21) Anmeldenummer: **80107395.8**

(22) Anmeldetag: **26.11.80**

(51) Int. Cl.³: **H 04 B 3/44,** G 01 R 31/00

(54) **Schaltungsanordnung zur Fernspeisung von Zwischenstellen einer Einrichtung der Nachrichtenübertragungstechnik mit Überwachung der Ausgangsspannung wenigstens einer Speisestelle.**

(30) Priorität: **30.11.79 DE 2948269**

(43) Veröffentlichungstag der Anmeldung:
**10.06.81 Patentblatt 81/23**

(45) Bekanntmachung des Hinweises auf die Patenterteilung:
**15.06.83 Patentblatt 83/24**

(84) Benannte Vertragsstaaten:
**AT BE CH DE FR GB IT LI NL SE**

(56) Entgegenhaltungen:
**EP-A-0 007 628**
**DE-A-2 260 335**

(73) Patentinhaber: **SIEMENS AKTIENGESELLSCHAFT,**
**Berlin und München Wittelsbacherplatz 2,**
**D-8000 München 2 (DE)**

(72) Erfinder: **Kraicar, Heinz, Dipl.-Ing., Lindenberg 60 a,**
**D-8134 Pöcking (DE)**
Erfinder: **Ziegler, Alfred, Dipl.-Ing., Laimer Platz 1,**
**D-8000 München 21 (DE)**

## Schaltungsanordnung zur Fernspeisung von Zwischenstellen einer Einrichtung der Nachrichtenübertragungstechnik mit Überwachung der Ausgangsspannung wenigstens einer Speisestelle

Die Erfindung bezieht sich auf eine Schaltungsanordnung zur Fernspeisung von Zwischenstellen einer Einrichtung der Nachrichtenübertragungstechnik mittels Gleichstrom-Reihenspeisung, wobei in einem Fernspeisekreis eine Reihenschaltung von zwei in Speisestellen der Nachrichtenübertragungseinrichtung vorgesehen, über ein Speiseadernpaar miteinander verbundenen Konstantstromquellen vorgesehen ist und wobei eine in einer ersten Speisestelle enthaltene erste Konstantstromquelle auf einen größeren Stromwert einstellbar ist als eine in einer zweiten Speisestelle enthaltene zweite Konstantstromquelle, so daß im Normalbetrieb nur die auf den größeren Strom eingestellte erste Speisestelle speist und wobei wenigstens an eine der beiden Konstantstromquellen eine Einrichtung zur Überwachung der Ausgangsspannung angeschlossen ist.

Eine derartige Schaltungsanordnung wurde bereits vorgeschlagen (EP-A-79 102 651.1).

Ferner ist eine Schaltungsanordnung zur Fernspeisung von Zwischenstellen mittels Gleichstrom-Reihenspeisung, bei der in einem Fernspeisekreis eine Reihenschaltung von zwei über ein Speiseadernpaar miteinander verbundenen Konstantstromquellen vorgesehen ist und bei der jede der beiden Konstantstromquellen derart bemessen ist, daß sie die ganze Übertragungsstrecke versorgen kann, z. B. aus »The Post Office Electrical Engineers' Journal«, Vol. 66, Part. 3, Oct. 1973, Seiten 135 bis 137 bekannt.

Bei der bekannten Schaltungsanordnung sind zum Zwecke des Berührungsschutzes an beiden Enden eines Fernspeisekreises Konstantstromquellen angeschlossen. Stimmen die beiden Konstantströme exakt überein und werden die beiden Adern des Speisekreises an irgendeiner beliebigen Stelle versehentlich über den Körperwiderstand einer Person miteinander verbunden, so führt eine solche fehlerhafte Verbindung dazu, daß an der Fehlerstelle die Spannung zusammenbricht und daß sich für die beiden Speisegeräte eine entsprechende Lastaufteilung einstellt. Die Anordnung hat den Zweck sicherzustellen, daß Personen, die die Speiseadern zufällig berühren, hierdurch nicht zu Schaden kommen können. Diese Funktion hat zur Voraussetzung, daß die von den Konstantstromquellen gelieferten Ströme möglichst gut übereinstimmen, da im Berührungsfalle der Differenzstrom über die fehlerhafte Querverbindung fließt.

Auf Koaxialkabelstrecken mit beidseitiger Fernspeisung über die Innenleiter mit konstantem Gleichstrom läßt sich ein sogenannter a/b-Schluß, d. h. eine fehlerhafte Verbindung zwischen einem Innenleiter und dem Außenleiter, entsprechend dem genannten älteren Vorschlag (EP-A-79 102 651.1) dann von den Speisestellen aus erkennen und ggf. über den Fernspeisekreis eindeutig orten, wenn die Potentialverteilung entlang der Strecke definiert verläuft. Dies läßt sich insbesondere dadurch erreichen, daß bei Normalbetrieb eines der beiden Speisegeräte auf verringerte Speisestromgabe fest oder nur für passiven Betrieb aufgrund einer Regelcharakteristik eingestellt ist, die in einem vorgegebenen Bereich der Ausgangsspannung Nennstrom und unterhalb dieses Arbeitsbereiches den verringerten Konstantstrom erzwingt.

Bei einer derartigen Speisung befindet sich der Potential-Nullpunkt innerhalb des auf den kleineren Strom eingestellten Speisegerätes. Jeder a/b-Schluß entlang der Strecke verursacht eine Verschiebung der Symmetriemitte der Speisespannung an beiden Geräten und kann daher gemeldet und ggf. auch eindeutig geortet werden, sofern die Mittenverschiebung die Ansprechgrenze einer zu diesem Zweck vorgesehenen Symmetrieüberwachungseinrichtung überschreitet. Ein a/b-Schluß am Streckenende nahe dem nicht speisenden Gerät verschiebt zwar ebenfalls die Symmetriemitten eindeutig, jedoch kann dieser Betrag so gering sein, daß er noch unter der Ansprechschwelle von in den beiden Speisestellen vorgesehenen Symmetrieüberwachungseinrichtungen liegt.

Bei Fernspeiseeinrichtungen mit einseitiger Speisung wird ein a/b-Schluß am Streckenende nicht erkannt; ein derartiger Schluß ist im Fall des Kabelbruches unwirksam, da er dann am Ende des abgetrennten und stromlosen Streckenteiles liegt. Bei beidseitiger Speisung sollte ein Symmetriefehler aber auch an dieser Stelle erkannt und gemeldet werden, da bei einem späteren Kabelbruch an einer vom Ort des a/b-Schlusses entfernten Stelle evtl. frei zugängliche Innen- und/oder Außenleiter unzulässige Berührungsspannungen gegen Erde führen können. Auch bei zusätzlich zu einer Nachrichtenübertragungsstrecke, z. B. zu Lichtwellenleitern vorgesehenen Speiseadern kann ein Erdschluß an der einen Stelle zu unzulässigen Berührungsspannungen an einer anderen fehlerhaften Stelle des Speiseadernpaares führen.

Aufgabe der Erfindung ist es, eine Schaltungsanordnung der eingangs genannten Art so auszubilden, daß mit möglichst einfachen Mitteln Erdschlüsse bzw. fehlerhafte Verbindungen zwischen dem Innen- und dem Außenleiter eines Kabels auch dann sicher gemeldet werden, wenn sie in der Nähe der im Normalbetrieb nicht speisenden Speisestelle gelegen sind.

Gemäß der Erfindung wird die Schaltungsanordnung zur Lösung dieser Aufgabe derart ausgebildet, daß die am Ausgang der zweiten Speisestelle angeschlossene Überwachungseinrichtung eine Vorrichtung zur Überwachung der Polung der beiden jeweils auf Bezugspotential bezogenen Ausgangsteilspannungen enthält und daß als Kriterium für eine Fehlermeldung eine Umpolung wenigstens einer der beiden Ausgangsteilspannungen dient.

Die Umpolung einer der beiden Ausgangsteilspannungen bedeutet a/b-Schluß bzw. Erdschluß auf der Strecke. Zwei gleichzeitig auftretende Fehlermeldungen bedeuten Schleifenschluß mit oder ohne Erdverbindung.

In weiterer Ausgestaltung der Erfindung wird die Schaltungsanordnung derart ausgebildet, daß die Überwachungsvorrichtung je Ausgangsteilspannung eine aus einem Meßwiderstand und einer derart gepolten Diode bestehende Serienschaltung enthält, daß die Dioden im speisenden Zustand des Speisegerätes gesperrt sind und daß an dem Meßwiderstand jeweils ein Schwellwertschalter angeschlossen ist. Zweckmäßigerweise ist dabei vorgesehen, daß bei den beiden Serienschaltungen die Dioden jeweils an einen der beiden mit dem Speiseadernpaar verbundenen Ausgangsanschlüsse der Speisestelle und die Meßwiderstände an die Symmetriemitte angeschlossen sind.

Durch diese Maßnahmen ergibt sich der Vorteil, daß die Dioden die ggf. sehr große Speisespannung, die bei speisender Speisestelle am Streckenanfang auftritt, vom Meßwiderstand und dem daran angeschlossenen Schwellwertschalter ferngehalten wird. Der Schwellwertschalter erhält somit lediglich den wesentlich kleineren Spannungsabfall, den der Fernspeisestromes am Innenwiderstand des passiven Gerätes hervorruft.

Zweckmäßigerweise ist an beide Schwellwertschalter je eine eigene Anzeigevorrichtung angeschlossen. Die Widerstandswerte der Meßwiderstände werden insbesondere wesentlich größer als die Streckenwiderstände bemessen. Vorzugsweise wird parallel zu den Serienschaltungen je ein Symmetriewiderstand angeordnet.

Führt man den Verbindungspunkt der beiden Symmetrierwiderstände über eine Einrichtung zur Symmetrieüberwachung an den Verbindungspunkt zweier weiterer Symmetrierwiderstände, so lassen sich Unsymmetrien nicht nur mit Hilfe der Schwellwertschalter quantitativ feststellen, sondern auch abhängig vom Überschreiten eines vorgegebenen Wertes zur Meldung bringen.

Der Innenwiderstand der zweiten Speisestelle, an dem die Ausgangsspannung abfällt, beträgt bei einem Fernspeisestrom von etwa 300 mA zweckmäßigerweise etwa 10 Ohm. Bei einer derartigen Bemessung läßt sich die Tatsache, daß eine Unsymmetrie vorliegt, in allen interessierenden Betriebsfällen sicher feststellen.

Die Erfindung wird anhand der in den Figuren dargestellten Ausführungsbeispiele näher erläutert.

Es zeigt

Fig. 1 eine Schaltungsanordnung zur unterbrechungslosen Fernspeisung von Zwischenstellen einer Nachrichtenübertragungseinrichtung,

Fig. 2 den Potentialverlauf bei der in Fig. 1 gezeigten Schaltungsanordnung bei ungestörtem Betrieb bzw. a/b-Schluß an einer Stelle der Strecke und

Fig. 3 eine Anordnung zur Überwachung der Polung der Ausgangsteilspannungen einer Speisestelle.

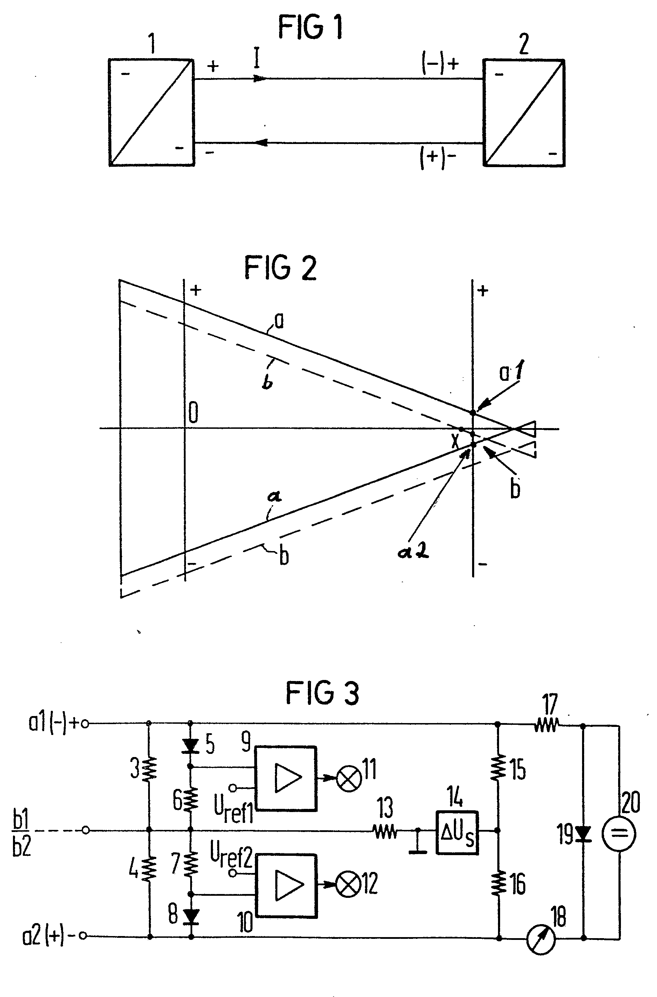

Fig. 1 zeigt eine Anordnung zur unterbrechungsfreien Fernspeisung von Zwischenstellen einer Einrichtung zur Nachrichtenübertragung die insbesondere Zwischenregeneratoren einer Lichtwellenleiter-Strecke sind.

Dabei läuft der Fernspeisekreis über Speiseadern, die gegebenenfalls zusätzlich zu den Lichtwellenleitern vorgesehen sind. Bei einer Nachrichtenübertragungsstrecke mit Koaxialleitungen, z. B. TF-Übertragungsstrecken, kann der Fernspeisekreis insbesondere über die Innenleiter der Kabel verlaufen.

Das Fernspeise-Adernpaar ist an beiden Enden jeweils an ein Fernspeisegerät 1 bzw. 2 angeschlossen, so daß sich eine beidseitige Speisung, mit gleichzeitig vorhandener Geräteredundanz ergibt. Dabei ist im Fernspeisekreis eine Reihenschaltung der beiden Fernspeisegeräte 1 und 2 wirksam. Jedes dieser beiden Fernspeisegeräte ist in der Lage, die ganze Fernspeisestrecke nach dem Prinzip der sogenannten »heißen Reserve« zu versorgen.

Fig. 2 zeigt den Potentialverlauf auf der Fernspeisestrecke. Das Geradenpaar a zeigt den Verlauf bei ungestörtem Betrieb bzw. bei Normalbetrieb und das Geradenpaar b für einen a/b-Schluß auf der Strecke in der Nähe des auf geringeren Strom eingestellten Speisegerätes.

Bei dem Fernspeisegerät 1 ist der Speisestrom auf den Nennwert $I_N$ eingestellt. Das andere Fernspeisegerät 2 ist dagegen auf einen Konstantstrom eingestellt, der um einige, insbesondere um etwa 5% unter dem Wert des Nennstromes $I_N$ liegt. Aufgrund des vom anderen Fernspeisegerät 1 eingeprägten höheren konstantstromes $I_N$ stellt sich am Ausgang des Fernspeisegerätes 2 eine nur geringe Spannung ein, die durch den Innenwiderstand des Fernspeisegerätes bedingt ist. Bei ungestörter Symmetrie ist der Anschluß a1 positiv, der Anschluß a2 negativ gegenüber der Symmetriemitte.

Ein Erkennen und Melden eines a/b-Schlusses, insbesondere an dem Streckenende, bei dem er zu geringe Spannungsverschiebungen bewirkt, läßt sich durch Überwachen der Polung der Ausgangs-Teil-Spannungen $U_{a1-b}$ bzw. $U_{a2-b}$ am Ausgang des passiv arbeitenden Gerätes erreichen. Diese Teil-Spannungen sind durch den Spannungsabfall des Fernspeisestromes am Innenwiderstand des passiven Gerätes bestimmt und besitzen deshalb die umgekehrte Polarität, wie die beim aktiven Arbeiten dieses Gerätes vorhandenen Fernspeise-Teilspannungen. Im Falle eines a/b-Schlusses verschwindet die negative Polarität der zugehörigen Teil-Spannung.

Bei der in Fig. 3 gezeigten Speisestelle ist die Stromquelle 20 über den Innenwiderstand 17 und den Strommesser 18 an die Anschlüsse a1 und a2 geführt. Der von der Stromquelle 20 abgegebene Strom ist derart bemessen, daß bei passivem Betrieb der Speisestelle, d. h. im nicht speisenden Zustand am Anschluß a1 positiv ist und am Anschluß a2 negatives Potential liegt. Bei aktivem Betrieb, d. h. im speisenden Zustand der Speisestelle kehrt sich die Polarität um, so daß am Anschluß a1 negatives und am Anschluß a2 positives Potential vorhanden ist.

Parallel zum Ausgang a1, a2 liegen zwei symmetrische Spannungsteiler, von denen der eine aus den Widerständen 3 und 4 und der andere aus den Widerständen 15 und 16 besteht. Der Verbindungspunkt der Widerstände 3 und 4 ist als Symmetriemitte der Speisestelle an den Anschluß b1, b2 geführt, und über den Widerstand 13 an Erde und von dort über Einrichtung 14 zur Symmetrieüberwachung an den Verbindungspunkt der Widerstände 15 und 16 geführt.

Parallel zur Stromquelle 20 liegt die Diode 19, die derart gepolt ist, daß sie für den von der Stromquelle 20 kommenden Strom gesperrt ist. Der Innenwiderstand 17 und der Strommesser 18 sind zwischen den Anschlüssen a1, a2 und der Diode 19 wirksam bzw. angeordnet, so daß sie auch von einem Strom durchflossen werden, der von der anderen, in Fig. 3 nicht dargestellten Speisestelle kommt.

Parallel zum Widerstand 3 liegt die aus der Diode 5 und dem Widerstand 6 bestehende Serienschaltung. Parallel zum Widerstand 4 ist die Serienschaltung aus dem Meßwiderstand 7 und der Diode 8 angeordnet. Die Dioden 5 und 8 sind so gepolt, daß sie für den Fall, daß die Speisestelle, in der sie enthalten sind, selbst speist, d. h. bei aktivem Betrieb gesperrt sind. Die Widerstände 6 und 7 sind in den Serienschaltungen so angeordnet, daß sie jeweils mit der Symmetriemitte b1, b2 verbunden sind.

An dem Verbindungspunkt der Diode 5 mit dem Meßwiderstand 6 ist die Überwachungseinrichtung 9 angeschlossen. Am Verbindungspunkt des Meßwiderstandes 7 mit der Diode 9 liegt die weitere Überwachungseinrichtung 10. Außerdem ist der Überwachungseinrichtung 9 die Referenzspannung $U_{Ref1}$ und der Überwachungseinrichtung 10 die weitere Referenzspannung $U_{Ref2}$ zugeführt. An den Ausgang der Überwachungseinrichtung 9 ist das Anzeigeelement 11, an den Ausgang der Überwachungseinrichtung 10 das Überwachungselement 12 angeschlossen.

Die Widerstände 3 und 4 sind als Symmetriewiderstände gleich bemessen. Auch die ebenfalls als Symmetrierwiderstände 15 und 16 dienenden Widerstände stimmen miteinander überein.

Die Umpolung der Ausgangspannung läßt sich in der beschriebenen Weise dadurch erfassen, daß bei Verschwinden des Ableitstromes durch einen der beiden Widerstände Streckenfehler-Alarm ausgelöst wird. Diese Überwachung erfaßt dann zugleich einen a1/a2-Schluß.

Die Dioden 5 und 8 der beiden Meßwege sind so gepolt, daß sie bei aktivem Speisebetrieb des sonst passiven Gerätes sperren; es wird damit verhindert, daß diese Meßwege beim Speisebetrieb einen Nebenschluß zur hochohmigen Symmetrierung bilden. Die Größe des Meßwiderstandes 6 bzw. 7 liegt wesentlich über dem Streckenwiderstand, so daß im Falle eines a/b-Schlusses auf der Strecke die dann vom Kabel bestimmte Spannungsaufteilung nicht verfälscht wird und die Wärmeverluste an dem Widerstand ausreichend niedrig bleiben. Eine Ortungsmöglichkeit im Fernspeisekreis durch Messen der Teilspannungen ist somit nach wie vor gegeben, wobei der Fehlerort durch das Verhältnis der beiden Ausgangsteilspannungen $U_{a1-b} : U_{a2-b}$ bestimmt ist.

Bei einer bevorzugten Ausführungsform der in Fig. 3 gezeigten Anordnung betragen die Werte der Widerstände 3 und 4 jeweils 2 MΩ, die Werte der Widerstände 15 und 16 jeweils 6 MΩ, der Fernspeisestrom 300 mA, die Sperrspannung der Dioden 5 und 8 jeweils 600 V, der Wert des Widerstandes 13 beträgt 1 MΩ. Die Ansprechgrenze der Einrichtung 14 beträgt z. B. 25 V. Der Innenwiderstand 17, der insbesondere eine Siebdrossel, einen Meßwiderstand und ggf. weitere Schaltmittel der Speisestelle enthält, ist so bemessen, daß an ihm ein deutlicher Spannungsabfall von insbesondere ca. 9 V auftritt.

## Patentansprüche

1. Schaltungsanordnung zur Fernspeisung von Zwischenstellen einer Einrichtung der Nachrichtenübertragungstechnik mittels Gleichstrom-Reihenspeisung, wobei in einem Fernspeisekreis eine Reihenschaltung von zwei in Speisestellen der Nachrichtenübertragungseinrichtung vorgesehenen, über ein Speiseadernpaar miteinander verbundenen Konstantstromquellen (1, 2, 20) vorgesehen ist und wobei eine in einer ersten Speisestelle enthaltene erste Konstantstromquelle (1) auf einen größeren Stromwert einstellbar ist als eine in einer zweiten Speisestelle enthaltene zweite Konstantstromquelle (2, 20), so daß im Normalbetrieb nur die auf den größeren Strom eingestellte erste Speisestelle speist und wenigstens an eine der beiden Konstantstromquellen eine Einrichtung zur Überwachung der Ausgangsspannung angeschlossen ist, dadurch gekennzeichnet, daß die am Ausgang der zweiten Speisestelle angeschlossene Überwachungseinrichtung eine Vorrichtung zur Überwachung der Polung der beiden jeweils auf Bezugspotential bezogenen Ausgangsteilspannungen enthält und daß als Kriterium für eine Fehlermeldung eine Umpolung wenigstens einer der beiden Ausgangsteilspannungen dient.

2. Schaltungsanordnung nach Anspruch 1, dadurch gekennzeichnet, daß die Überwachungsvorrichtung je Ausgangsteilspannung eine aus einem Meßwiderstand (6, 7) und einer derart gepolten Diode (5, 8) bestehende Serienschaltung enthält, daß die Dioden (5, 8) im speisenden Zustand des Speisegerätes gesperrt sind und daß an den Meßwiderstand (6, 7) jeweils ein Schwellwertschalter (9, 10) angeschlossen ist.

3. Schaltungsanordnung nach Anspruch 2, dadurch gekennzeichnet, daß bei den beiden Serienschaltungen die Dioden (5, 8) jeweils an einen der beiden mit dem Speiseadernpaar verbundenen Ausgangsanschlüsse der Speisestelle und die Meßwiderstände (6, 7) an die Symmetriemitte angeschlossen sind.

4. Schaltungsanordnung nach Anspruch 2 oder 3, dadurch gekennzeichnet, daß an beide Schwellwertschalter (9, 10) je eine eigene Anzeigevorrichtung (11, 12) angeschlossen ist.

5. Schaltungsanordnung nach einem der Ansprüche 2 bis 4, dadurch gekennzeichnet, daß die Widerstandswerte der Meßwiderstände (6, 7) wesentlich größer als die Streckenwiderstände bemessen sind.

6. Schaltungsanordnung nach einem der Ansprüche 1 bis 5, dadurch gekennzeichnet, daß parallel zu den Serienschaltungen je ein Symmetrierwiderstand (3, 4) angeordnet ist.

7. Schaltungsanordnung nach einem der Ansprüche 1 bis 6, dadurch gekennzeichnet, daß der Verbindungspunkt der beiden Symmetrierwiderstände (3, 4) über eine Einrichtung (14) zur Symmetrierüberwachung an den Verbindungspunkt zweier weiterer Symmetrierwiderstände (15, 16) geführt ist.

8. Schaltungsanordnung nach einem der Ansprüche 1 bis 6, dadurch gekennzeichnet, daß der Innenwiderstand der zweiten Speisestelle, an dem die Ausgangsspannung abfällt, bei einem Fernspeisestrom von etwa 300 mA, etwa 10 Ω beträgt.

## Claims

1. A circuit arrangement for the remote feeding of intermediate stations by means of direct current series feeding in a device relating to communications transmission technology, wherein in a remote supply circuit there is a series connection of two constant current sources (1, 2, 20) arranged in supply stations of the communications transmission device and connected to one another by means of a pair of supply lines, and wherein a first constant current source (1) contained in a first supply station is adjustable to a larger current value than a second constant current source (2, 20) contained in a second supply station, so that in normal operation only the first supply station set to the larger current feeds, and a device for monitoring the output voltage is connected to at least one of the two constant current sources, charakterised in that the monitoring device, which is connected to the output of the second supply station, comprises a device for monitoring the polarity of the two partial output voltages which are respectively related to reference potential, and that a reversal of polarity of at least one of the two partial output voltages serves as criterion for an error message.

2. A circuit arrangement as claimed in Claim 1, characterised in that for each partial output voltage the monitoring device comprises a series connection which consists of a measuring resistor (6, 7) and a diode (5, 8) poled in such manner that the diodes (5, 8) are blocked in the feeding state, and that a threshold value switch (9, 10) is connected to the measuring resistor (6, 7) in each case.

3. A circuit arrangement as claimed in Claim 2, characterised in that in the two series connections, the diodes (5, 8) are respectively connected to one of the two output terminals of the supply station connected to the pair of supply lines, and the measuring resistors (6, 7) are connected to the centre of symmetry.

4. A circuit arrangement as claimed in Claim 2 or 3, characterised in that a separate display device (11, 12) is connected to each of the two threshold value switches (9, 10).

5. A circuit arrangement as claimed in one of Claims 2 to 4, characterised in that the resistance values of the measuring resistors (6, 7) are dimensioned so as to be substantially higher than the section resistances.

6. A circuit arrangement as claimed in one of Claims 1 to 5, characterised in that a balancing resistor (3, 4) is connected in parallel to each of the series connections.

7. A circuit arrangement as claimed in one of Claims 1 to 6, characterised in that the connection point of the two balancing resistors (3, 4) is led to the connection point of two further balancing resistors (15, 16) by means of a device (14) which serves for the balancing monitoring operation.

8. A circuit arrangement as claimed in one of Claims 1 to 6, characterised in that the internal resistance of the second supply station, at which the output voltage drops, amounts to approximately 10 Ω with a remote supply current of approximately 300 mA.

## Revendications

1. Dispositif pour la téléalimentation de stations intermédiaires d'une installation de la technique de la transmission d'informations à l'aide d'une alimentation série en courant continu, du type dans lequel il est prévu dans un circuit de téléalimentation un circuit série de deux sources de courants constants (1, 2, 20) prévues dans des stations d'alimentation de l'installation de transmission d'informations et reliées entre elles par une paire de fils d'alimentation, et dans lequel une première source de courant constant (1) prévue dans une première station d'alimentation est susceptible d'être réglée à un courant de plus grande valeur que celle d'une seconde source de courant constant (3, 20) contenue dans une seconde station d'alimentation, en sorte que dans le cas du fonctionnement normal seule la première station d'alimentation qui est réglée sur le courant de plus grande valeur fournit une alimentation, une installation pour surveiller la tension de sortie étant branchée au moins sur l'une des deux sources de courant constant, caractérisé par le fait que l'installation de surveillance branchée sur la sortie de la seconde station d'alimentation comporte un dispositif pour surveiller la polarité des deux tensions partielles de sortie rapportées respectivement à un potentiel de référence, et que comme critère pour la signalisation d'un défaut on se sert d'un changement de polarité d'au moins l'une des deux tensions partielles de sortie.

2. Dispositif selon la revendication 1, caractérisé par le fait que l'installation de surveillance comporte, par tension partielle de sortie, un circuit série constitué par une résistance de mesure (6, 7) et, par une diode (5, 8) montée avec une polarité telle que les diodes (5, 8) sont bloquées lorsque l'appareil d'alimentation est dans son étant d'alimentation, et qu'à chaque résistance de mesure (6, 7) est relié un commutateur à valeur de seuil (9, 10).

3. Dispositif selon la revendication 2, caractérisé par le fait que dans les deux circuits série, les diodes (5, 8) sont respectivement reliées à l'une des deux bornes aux deux sorties de la station d'alimentation qui sont reliées à la paire de fils d'alimentation, et que les résistances de mesure (6, 7) sont reliées au milieu de symétrie.

4. Dispositif selon la revendication 2 ou 3, caractérisé par le fait qu'à chacun des deux commutateurs à valeur de seuil (9, 10) est relié à un dispositif indicateur propre (11, 12).

5. Dispositif selon l'une des revendications 2 à 4, caractérisé par le fait que les valeurs des résistances de mesure (6, 7) sont supérieures aux résistances des voies.

6. Dispositif selon l'une des revendications 1 à 5, caractérisé par le fait qu'en parallèle sur chacun des circuits série est disposée une résistance d'équilibrage (3, 4).

7. Dispositif selon l'une des revendications 1 à 6, caractérisé par le fait que le point de liaison des deux résistances d'équilibrage (3, 4) est relié, par l'intermédiaire d'un dispositif (14) de surveillance de l'équilibrage, au point de liaison de deux autres résistances d'équilibrage (15, 16).

8. Dispositif selon l'une des revendications 1 à 6, caractérisé par le fait que la résistance interne de la seconde station d'alimentation, au niveau de laquelle la tension de sortie chute, est d'environ 10 Ω pour un courant de téléalimentation d'environ 300 mA.

## FIG 1

## FIG 2

## FIG 3